(19)

**Europäisches Patentamt**
**European Patent Office**
**Office européen des brevets**

(11) **EP 4 300 579 A1**

(12) **EUROPEAN PATENT APPLICATION**

(43) Date of publication:
**03.01.2024  Bulletin 2024/01**

(21) Application number: **22465542.3**

(22) Date of filing: **27.06.2022**

(51) International Patent Classification (IPC):
**H01L 27/142** (2014.01)   **H01L 27/144** (2006.01)
**H01L 31/07** (2012.01)   **H01L 31/0224** (2006.01)

(52) Cooperative Patent Classification (CPC):
**H01L 27/142; H01L 28/40; H01L 31/022433;**
**H01L 31/07**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicants:
• **SC Nanom Mems Srl**
 **505400 Rasnov, jud Brasov (RO)**
• **Tyndall National Institute**
 **T12 R5CP Cork (IE)**

(72) Inventors:
• **COBIANU, Cornel**
 **051434 Bucharest (RO)**
• **GHEORGHE, Marin**
 **505400 Rasnov, Jud.Brasov (RO)**
• **MODREANU, Mircea**
 **Cork (IE)**

(74) Representative: **Fierascu, Cosmina-Catrinel**
 **Rominvent SA**
 **35 Ermil Pangratti Street**
 **Sector 1**
 **011882  Bucharest (RO)**

(54) **ON-CHIP INTEGRATED PLASMONIC ENERGY HARVESTER, MICROSUPERCAPACITOR AND SENSOR, AND FABRICATION METHOD FOR THE SAME**

(57)   The present disclosure presents an innovative design and technology concept for an on-chip integrated self-powered nano and microsystem containing a plasmonic interdigitated metal-semiconductor-metal (SMS) Schottky thin film solar cell as energy harvester, an in-plane interdigitated supercapacitor as power source, and a sensor with interdigitated electrodes. The sensor can be an interdigitated plasmonic MSM hot electron Schottky photodetector, or an ultralow power chemiresistive gas sensor. The photoactive material of plasmonic solar cell and photodetector and the electroactive material of microsupercapacitor are based on the same chalcogenide semiconductor, like $Sb_2S_3$, and similar materials. The three modules of the self-powered on-chip integrated nano and microsystem are all connected in series and have a common electrode between the solar cell and supercapacitor and another one between the supercapacitor and the sensor. Novel design concepts for multiband, chirped wideband and, multi-polarization plasmonic solar cells and photodetectors are also disclosed here.

Fig. 2

EP 4 300 579 A1

**Description**

Technical field

The invention is related to a novel concept for the design and fabrication of integrated nano and microsystems containing a solar cell plasmonic energy harvester, one or more supercapacitors which are powering a sensor located on the same chip. Embodiments are related to thin film solar cells based on interdigitated metal-semiconductor-metal (MSM) Schottky barriers at the interface between a metal and a chalcogenide semiconductor, with enhanced light absorption and quantum efficiency by surface plasmon polariton resonances at that interface. Embodiments are related to on-chip planar interdigitated supercapacitors with electrodes based on the same chalcogenides materials. Embodiments are related to low-power sensors like interdigitated hot electron MSM Schottky plasmonic photodetectors, or gas sensors, which are powered by the above energy harvester and microsupercapacitor located on the same chip with the sensor.

## BACKGROUND OF THE INVENTION

The continuous trend of complex, multifunctional nano and microsystem integration required by the Internet of Thing (IoT) and present digitalization age has driven a major focus on the development of on-chip-powered autonomous sensing nano and microsystems able to detect biochemical and physical parameters from the ambient, to process locally the information and to send it wirelessly to the upper level for further processing and decision making. Traditionally, such self-powered systems use a battery as an energy source for all portable instruments. The disadvantage of these mobile electronic systems is the requirement for the periodic change of the battery, and thus a temporary system operation interruption.

A major step forward in the increase of the reliability of such self-powered integrated systems is made by replacing the battery with on-chip energy harvesting devices. Thus, the interruptions due to the battery exhaustion can be solved and a continuous operation can be assured. One of the challenges of a stable operation of such energy harvesting-based systems is the fluctuation of those energy sources, like in the case solar or eolian energy. For solving at least partially this issue, in the last seventy years, the technology of the supercapacitors was developed. Such supercapacitors can store the energy received from a fluctuating energy source and provide it to the electric or the electronic circuit as a stabilized energy.

These supercapacitors or ultracapacitor devices fill the gap between the battery and electrolytic capacitors, in the sense that they are energy storage components which have an energy density lower than that of battery, but much higher than of an electrolytic capacitor. On the other hand, the power density of the supercapacitor is higher than that of battery and lower than that of an electrolytic capacitor. Due to these high-power density characteristics of supercapacitors, novel specific industrial applications appeared like power buffer during electric and hybrid car acceleration.

In the effort to replace the battery with regenerable energy sources and supercapacitors for energy storage, a plethora of technologies are under research, and some of them are briefly described here. Thus, in the paper of Zhang et al (Zhitao Zhang, Xuli Chen, Peining Chen, Guozhen Guan, Longbin Qiu, Huijuan Lin, Zhibin Yang, Wenyu Bai, Yongfeng Luo, and Huisheng Peng, Integrated Polymer Solar Cell and Electrochemical Supercapacitor in a Flexible and Stable Fiber Format, Adv. Mater. 2013, DOI: 10.1002/adma.201302951) an "energy fiber" is developed by connecting a polymer solar cell as an energy source and a solid-state supercapacitor as an energy storage component. The two devices are sharing a common electrode of anodized titanium (Ti) wire on which Ti nanotubes were grown by anodization. On the solar cell side, the light absorption and conversion into electric current is performed via a polymeric composite layer containing poly(3-hexyl thiophene):phenyl-C 61-butyric acid methyl ester (P3HT:PCBM) and poly(3,4-ethylenedioxythiophene): poly (styrene sulfonate) (PEDOT:PSS). The second electrode of solar cell is made of multiwalled carbon nanotube (MWCNT). On the supercapacitor side, the porous titanium electrode is covered with poly vinyl alcohol (PVA)-$H_3PO_4$ gel as electrolyte, while the second electrode is again MWCNT. During charging time of the supercapacitor, the solar cell and capacitor are electrically connected in parallel and electrical energy is stored. During discharging-time the supercapacitor works as an energy source and it powers an external circuit.

A photo-supercapacitor was proposed as a combination of a dye-sensitized solar cell (DSSC) and a supercapacitor, acting as electrical energy delivery system, while a common electrode has simplified the construction and device use. (C.H. Ng, H.N. Lim, S. Hayase, I. Harrison, A. Pandikumar, N.M. Huang, Potential active materials for photo-supercapacitor: A review, Electrochimica, Actahttp: // dx.doi.org /10.1016/ j.electacta .2017.04.003). An integrated version of this photo-supercapacitor concept has been also published, where the DSSC cell contains a compact and mesoporous titania ($TiO_2$) electrode as high specific area photoanode for electrolyte diffusion, a counter electrode of polypyrroles/reduced graphene oxide (PPY/rGO), which acts also as electroactive material for both electrodes of the symmetrical supercapacitor based on hydrogel electrolyte. (S.C.Lau, H.N.Lim, T.B.S.A.Ravoof, M.H.Yaacob, D.M.Grant, R.C.I.MacKenzie, I.Harrison, N.M.Huang, A three-electrode integrated photo-supercapacitor utilizing graphene-based intermediate bifunctional electrode, Electrochimica Acta http://dx.doi.org/10.1016/j.electacta.2017.04.003.

Integration of printed solar cells based on the solid-state semiconductors like silicon, GaAs, or CIGS (copper-indium-gallium-diselenide), and more recent perovskite materials with printed supercapacitor, based on $MnO_2$ doped with nanocarbonic materials as positive electrode, vanadium nitride (VN) as negative electrode and $MgSO_4$-polyacrylamide (PAM) as quasi-solid state electrolyte has provided outstanding volumetric energy densities of 13.1 mWhcm$^{-3}$ and high power densities of 440 mWcm$^{-3}$. (Zhengnan Tian, Xiaoling Tong, Guan Sheng, Yuanlong Shao, Lianghao Yu, Vincent Tung, Jingyu Sun, Richard B. Kaner, and Zhongfan Liu, Printable magnesium ion quasi-solid-state asymmetric supercapacitors for flexible solar-charging integrated units, NATURE COMMUNICATIONS | (2019) 10:4913 | https://doi.org/10.1038/s41467-019-12900-4 | www.nature.com/naturecommunications). Here, the integration of the solar cell-based energy harvester and the supercapacitor consists in performing the interdigitated supercapacitor on one face of a flexible polyimide (PI) substrate with the electrodes described above, while on the other face of the PI foil, it is sticked another foil containing the solar cell, and then, the entire tandem is packaged in between two protecting plastic films. This 3D stacked energy supply unit has dimensions in the range of one or two hundreds of mm$^2$, and its size may depend on the energy needed to be supplied by this integrated unit. As an example, a self-powered wireless sensor, which will transmit information with a speed rate of 500Kb/s and with a power consumption of 10 nW/bit may require a power consumption of 5 mW (Zhong Lin Wang, Self-Powered Nanosensors and Nanosystems, Adv. Mater. 15 November 2011, 1-6, doi.org/10.1002/adma.201102958) during this active working time, which should be delivered by the energy harvester and supercapacitor.

In addition to the value of power requested by self-powered electronic circuits, the value of the supply voltage which should be provided by the integrated energy harvester and supercapacitor is an important design parameter for the energy delivery unit. For example, the maximum voltage delivered by a solar cell is equal to the open circuit voltage (at zero electrical current) and in the case of very thin silicon heterojunction solar cell is up to 754 mV. It is obvious that when higher voltages are necessary, more solar cells are electrically connected in series. In a similar manner, the maximum voltage which can be applied to a supercapacitor is limited by the voltage at which chemical decomposition of the electrolyte takes place. For the case of an aqueous electrolyte, this voltage is equal to 1.23 eV, while for organic electrolytes, this value can go up to 4-5 volts. Beyond these values, the supercapacitor deteriorates rapidly, due to gaseous products evolution (like $H_2$ and $O_2$ in the case of aqueous electrolytes) by the electrolysis process. Again, it is obvious that more supercapacitors can be connected electrically in series for fitting the voltage value provided by the energy harvester and the value required by the circuit to be powered. Similarly, in the case of a high current demand by the circuit to be powered, the solar cells and the supercapacitors can be connected electrically in parallel.

For a better understanding of the present invention, a few key aspects about thin films solar cells will be described, as follows. The prior art in the field of the solar cell devices contains the so-called solar cells based on Schottky contact between a metal and an n-type semiconductor. Specific to this Schottky diode is the fact that an energy barrier and a depletion region between the metal and semiconductor are formed at the interface between metal and semiconductor, due to the difference between the work function of the metal and the semiconductor. Actually, when the Fermi level in the semiconductor is closer to the vacuum level, the electrons from the surface of the semiconductor will be transferred to the metal, and thus a depletion of electrons in the semiconductor and an electric field at the interface appear. It is this electric field from the interface which is separating the electrons and the holes which are generated in the semiconductor when a photon with an energy higher than the band gap is absorbed in the semiconductor. The motion of these separated charges in the external circuit will determine the current delivered by the solar cell. The barrier height of this Schottky solar cell is related to the open circuit voltage of the solar cell, and finally, to the value of the photovoltaic conversion of the solar energy into electric energy. This result has triggered a major effort for selecting the metal and an appropriate interface layer the surface of the semiconductor so that to maximize the open circuit voltage and conversion efficiency of the solar cell, as described in the patent US 4213798.

In the case when the energy of the incident photons is smaller than the band gap of the semiconductor, but higher than the Schottky barrier from the metal-semiconductor interface, then, the energetic ("hot") electrons from metal will be able to surmount the barrier height and travel to the conduction band of semiconductor and from there to the external circuit, and thus contributing to the generated current of the solar cell. This is the so-called internal photoemission (IPE) process. The quantum efficiency of these hot-electrons is relatively low, i.e., 1-2%, due to the reduced number of metal electrons which are able to surmount the barrier. Therefore, the photovoltaic current of the Schottky solar cell is obtained not only from photo electron-hole pairs generated in the semiconductor, but also from the hot electrons extracted from the metal. Thus, the absorption spectrum of a solar cell of Schottky type will increase due to absorbed photons of longer wavelengths generating hot electrons. As the solar light spectrum contains a large wavelength spectrum, from ultraviolet (UV), to visible (VIZ) and infrared (IR), such a Schottky solar cell can absorb a larger light spectrum, where both visible and near-infrared light can be absorbed and thus a higher value of the photocurrent is obtained.

Interdigitated Metal-Semiconductor-Metal (MSM) Schottky photodetector represents a further simplification of the solar cell fabrication technology, where the comb-like electrodes of the device are located in the same plane, either above the semiconductor layer, or, directly on the substrate below the semiconductor layer. The MSM Schottky photodetector consists of two Schottky contacts connected back-to-back. When a voltage is applied, one Schottky contact is forward biased and the other is reverse biased. The theory of this device can be found in the paper of Sze et al (S.M. Sze, D.J. Coleman Jr., and A Loya, Current transport in metal-semiconductor-metal (MSM) structures, Solid-State Electronics, 1971, vol. 14, pp. 1209-1218. On this direction, interdigitated MSM Schottky diode has been intensively used in photodetectors where short transit-time between the device electrodes is required, like in the case of the photodiodes for long wavelengths optical communications (Julian B.D. Soole and Herman Schumacher, InGaAs Metal-Semiconductor-Metal Photodetectors for Long Wavelength Optical communications, IEEE Journal of Quantum Electronics vol. 27, No. 3, March 1991).

The novelty of the on-chip electrical energy harvesting concept developed within this invention comes from the use of a plasmonic thin film solar cell based on interdigitated MSM Schottky device where the photoactive film is a multifunctional chalcogenide semiconductor, like the antimony trisulfide, $Sb_2S_3$, with an energy band gap of about 1.7 eV, when the film is in the polycrystalline state. The absorption edge of this chalcogenide material is about 0.72 $\mu$m, which means that this solar cell works well for the visible light spectrum, while it is transparent in the infrared (IR) spectrum. Therefore, the Schottky solar cell based on $Sb_2S_3$ absorber will be efficient in converting visible light into electrical energy. In addition, the sub bandgap photons can be also absorbed in the metal near interface, generating hot electrons which contribute to the photocurrent, too. The plasmonic solar cell performed in silicon technology is known in the art (Yoon Hee Jang, Yu Jin Jang, Seokhyoung Kim, Li Na Quan, Kyungwha Chung,and Dong Ha Kim, Plasmonic Solar Cells: From Rational Design to Mechanism Overview ∗,†DOI: 10.1021/acs.chemrev.6b00302, Chem. Rev. 2016, 116, 14982-15034) and it was motivated by the increase of the light absorption in the absorber material due to the surface plasmon polaritons (SPP) generation, as a decaying light wave at the interface between a metal and a dielectric or semiconductor. These SPP's are generated when the momentum conservation law between the incident photons, the surface plasmons and a grating placed on the surface of the photonic device is fulfilled (C. Genet and T.W. Ebbesen, Light in tiny holes, Natures, vol. 445, 4 January 2007). Such an increase in light absorption in plasmonic devices is due to the extraordinary high intensity of light transmission through subwavelength metal gratings or a periodic distribution of metal nanodots on the light absorbing surface, a photonic process which is also accompanied by an enhancement of the electric field at the interface between metal and dielectric or semiconductor. Such an enhanced electric field will further contribute to the efficient separation of photogenerated charge carrier and photocurrent enhancement. Due to the increased light absorption and photocurrent, the photovoltaic conversion efficiency of plasmonic solar cell will increase.

The equation for the momentum conservation is mathematically described below. As the momentum of the surface plasmons is higher than the momentum of the incident light, the generation of the surface plasmon at the metal-dielectric or metal-semiconductor interface in the presence of incident light is possible only by introduction of a prism, a topological defect (subwavelength hole) or a periodic corrugation of metal surface, or a metal grating, which contributes with the missing momentum. Thus, the momentum conservation law between (i) the surface plasmon ($\hbar k_{spp}$; where $k_{spp}$ is the wave vector of the surface plasmon and $\hbar$ is the reduced Planck constant),(ii) incident light ($\hbar * k_o$; where $k_o=\omega/c=2\pi/\lambda$ is magnitude of wave vector of incident light in free space,) and (iii) the topological defect, like a grating ($\hbar * k_\Lambda$; where $k_\Lambda=2\pi/\Lambda$ is the magnitude of the wave vector, $k_\Lambda$, of the grating and $\Lambda$ is the period of the grating, while the direction of $k_\Lambda$ vector is perpendicular to the length of the parallel digits) will be fulfilled if:

$$k_{spp}=k_o*\sin(\theta)+i* k_\Lambda \qquad\qquad [1]$$

where $\theta$ is the incidence angle of the light, i is an integer, and $k_{spp}$ is the wave vector of the surface plasmon polaritons, which is a complex vector having a magnitude (wave number) given by the relation:

$$k_{spp}= (\omega/c) * \sqrt[2]{(\varepsilon m * \varepsilon d)/(\varepsilon m + \varepsilon d)} \qquad\qquad [2]$$

For the fulfillment of momentum conservation law from equation [1], in practice one considers the real part of the wave number from equation [2], where $\varepsilon m$ is the real part of the metal permittivity, which is a negative number for plasmonic metals in the optical spectrum, while $\varepsilon d$ is the real part of the permittivity of the dielectric or semiconductor, which is a positive number in the same domain. Therefore, from equation [2], it is easy to notice that SPP wave number is real number when $\varepsilon m$ is smaller than - $\varepsilon d$. (C. Genet and T. W. Ebessen, Light in tiny holes, Nature Reviews, vol. 445, 4 January 2007). Therefore, at a certain incident wavelength, the $k_{spp}$ value from equation [2], should be a real number for the generation of the surface plasmon polaritons at a certain incident wavelength given by equation [1], for a certain metal/dielectric or metal/semiconductor interface.

From the best of our knowledge, the plasmonic thin film interdigitated MSM Schottky solar cell based on the chalcogenide semiconductors was not reported before. Instead, there is a good knowledge about $Sb_2S_3$-based solar

cell, which does not contain a plasmonic grating, and where it is shown that by optimizing the height of Schottky barrier, a solar cell efficiency equal to 7.2% can be obtained. (O. Savadogo, and K.C. Mandal, Low Cost Schottky Barrier Solar Cells Fabricated on CdSe and Sb2S3 Films Chemically Bath Deposited with Silicotungstic Acid, Journal of Electrochemical Society vol. 141, No. 10, 1994, pp. 2871-2877). The thin film interdigitated MSM Schottky plasmonic solar cell has a simple fabrication technology and the interdigitated metal electrodes of the device have a dual function, i.e., electrical role as for device contacting and optical role as a metallic grating for the SPP's generation at the interface between metal and semiconductor.

The plasmonic solar cells are photonic devices which are wavelength and polarization-selective devices, which means that the solar cell is enhancing the light absorption only for the resonant wavelengths, able to generate SPP's. The resonant wavelength can be designed from the fulfillment of the momentum law conservation, as described above. From the mathematical equations [1] and [2], the period of the metallic grating which is assuring the SPP's generation at a specific wavelength is calculated. As an efficient energy harvesting device will always require a wide band absorption of the light, the present invention will present for the first time a novel concept of wide band plasmonic energy harvester, where the metal grating of the interdigitated MSM Schottky will be designed either as a multiband device, or with wideband chirped geometry, where a rather quasi-continuous variation of grating period will be designed. Thus, the plasmonic solar cell will assure an increase of the absorbed light spectrum.

In addition, the polarization sensitivity of the plasmonic solar cell means that the maxim photocurrent of the solar cell is obtained only when the electric field of the incident light, $E_L$ is colinear to the direction of the grating vector, $k_\Lambda$, (M. Jestl, I. Maran, A. Kock, W. Beins,tingl and E. Gornik, Polarization sensitive surface plasmon Schottky detectors, OPTIC LETTERS, vol. 14, No.14, July 15, 1989), as it will become clear in the invention description. An original geometry of the grating will reduce the effect of the polarization sensitivity on the photocurrent amplitude, as it will be disclosed by the present invention.

As already mentioned above, there is a strong trend of the on-chip integration of supercapacitors together with solar cell-based energy harvesters. The novelty of the approach from this patent consists in using the same technology for both plasmonic solar cell, planar supercapacitor and the plasmonic sensor which is powered by the supercapacitor, where there is also a common electrode between the solar cell and the supercapacitor and between the supercapacitor and the sensor powered by the supercapacitor. For this invention, the electroactive material for the supercapacitor electrode is the same semiconductor chalcogenide, like $Sb_2S_3$, used as photoactive absorber for the plasmonic solar cell which is deposited on a plasmonic current collector like a gold/titanium layer. As electrolyte, one can use a quasi-solid-state material like $MgSO_4$-polyacrylamide (PAM). The use of $Sb_2S_3$ as electroactive material is well known in the art, and it was proved recently that a maximum specific capacitance of 248 F/g at a current of 0.5 A/g was obtained. (Karade, Swapnil S. et al, Novel Application of Non-Aqueous Chemical Bath Deposited Sb2S3 Thin Films as Supercapacitive Electrode, in International Journal of Hydrogen Energy 41.46 (2016): 21278-21285).

Such a photonic sensor which can be fabricated on the same chip and with the same technology as that used for the solar cell and the supercapacitor is a plasmonic interdigitated MSM Schottky photodetector, where the photoactive material is again a chalcogenide semiconductor, like $Sb_2S_3$ described above. The wavelength spectrum of the electromagnetic radiation to be detected by the plasmonic photodetector depends on the band gap of chalcogenide material and the barrier height of the Schottky contact formed between the plasmonic metal and the semiconductor. Under these considerations, such a $Sb_2S_3$ based plasmonic photodetector can be used for the detection of visible light for photons with energy higher than the bandgap, as well as near infrared radiation, in the telecom wavelength band (1260-1675 nm) when the Schottky barrier has a height lower than 0.75 eV and the photons absorbed in the metal near interface will generate hot electrons surmounting the barrier. If it is required to detect only the near-infrared radiation, then the period of the grating will be designed so that the visible light to be rejected. This is possible, as the plasmonic device can operate as a wavelength filter, as discussed above.

The family of the on-chip sensors powered by our disclosed energy harvester can be enlarged by other types of sensors, where a sensitive layer can be deposited on the interdigitated electrodes, like in the case of room temperature chemiresistive gas sensors, which will be also disclosed here. For example, in the paper of Cobianu et al., (Cornel Cobianu, Bogdan-Catalin Serban, Niculae Dumbravescu, Octavian Buiu , Viorel Avramescu, Cristina Pachiu, Bogdan Bita, Marius Bumbac,Cristina-Mihaela Nicolescu and Cosmin Cobianu, Organic-Inorganic Ternary Nanohybrids of Single-Walled Carbon Nanohorns for Room Temperature Chemiresistive Ethanol Detection, Nanomaterials 2020, 10, 2552; doi:10.3390/nanol0122552), a room temperature chemiresistive ultra low power gas sensor for ethanol detection has operated with less than 2 mW for sensing with short response time, low concentrations of ethanol specific to the alcohol testers. Similarly, in the paper of Serban et al. (Serban, B.-C.; Cobianu, C.; Buiu, O.; Bumbac, M.; Dumbravescu, N.; Avramescu, V.; Nicolescu, C.M.; Brezeanu, M.; Pachiu, C.; Craciun, G.; et al. Ternary Nanocomposites Based on Oxidized Carbon Nanohorns as Sensing Layers for Room Temperature Resistive Humidity Sensing. Materials 2021, 14, 2705. https://doi.org/10.3390/ma14112705), it is described an ultralow power room temperature chemiresistive sensor for the detection of relative humidity by means of sensitive layer consisting of graphene oxide-oxidized carbon nanohorns-polyvinylpyrrolidone.

A relevant prior art patent included here as reference is the US Patent 11127865 B2 where an integrated energy harvesting and storage device is disclosed. The solar cell-based energy harvester has a common electrode with the supercapacitor, the entire energy delivering unit being fabricated in a stack layer technology, as follows. The layers of the solar cell described from the top to the bottom are: transparent top electrode from indium tin oxide (ITO), a hole transport layer (PEDOT-PSS), a light harvesting perovskite layer (active layer), an electron transport layer (PCBM layer) and a negative electrode (current collector made of copper ribbon). The copper electrode is common to the solar cell and the supercapacitor, which is located below the solar cell. The surface of the common copper electrode oriented towards the supercapacitor is functionalized with copper hydroxide nanotubes (CuONT) by rapid thermal oxidation at about 500°C, which is then covered with a thin metallic layer of aluminum, to render electric conductivity to this electrode. The electroactive material like $MnO_2$ is then electrodeposited on this electrode. The second electrode of the supercapacitor is made of copper ribbon again, functionalized as above with hydroxide nanotubes (CuONT), on which the polyvinyl alcohol containing quasi-solid-state potassium hydroxide gel electrolyte is glued on the CuONT. The solar cell-supercapacitor tandem is provided with two switches, which operate in opposition, i.e., when one is closed the other is open. The first switch, when it is closed, it makes the connection between the transparent electrode of solar cell and the second electrode of the supercapacitor and thus the supercapacitor is charged. The second switch, when it is closed, it makes the connection between the supercapacitor and the external circuit (load), and thus the supercapacitor starts to discharge by becoming a power supply for that circuit. During charging of the supercapacitor, the second switch is open, and the first switch is closed as mentioned. During discharging, the first switch is open and the second switch is closed, as mentioned. Such an integrated energy delivery unit can be embedded in a woven for making smart clothes.

Another patent relevant to our disclosure is the patent WO 2018/195383 A1 which discloses the on-chip fabrication of the supercapacitors and photodetectors based on 2D transition metal chalcogenides (TMC), like $MoS_2$, where a 2D chalcogenide material is used as both photosensitive material in photodetectors and electroactive material in interdigitated supercapacitors. This patent shows that by using different semiconducting chalcogenides like $SnSe_2$, and $NbSe_2$ for photodetector fabrication one can detect visible light and near infrared light (NIR), respectively, according to the band gap value of each semiconductor. The photodetectors are simply fabricated by depositing metal contacts on the patterned TMC semiconductor, acting simultaneously as an interdigitated electrode for the supercapacitor. The electrode of the supercapacitor is also described as a stack of a TMC layer and a transition metal oxide (TMO) layer, where the TMC layer is obtained by conversion of a portion of the $MO_2$ layer to $MoS_2$ layer by an ion exchange process. The interconnection between supercapacitor and photodetector is not clearly described, while the photodetector is at least partially powered by an external power supply. The added value of our invention with respect to this prior art invention comes from the extension of multifunctionality of the chalcogenide material, which is used here as photoactive semiconductor for solar cell, photodetector and electroactive electrode for microsupercapacitor, while original plasmonic photonic devices, as plasmonic solar cells and plasmonic photodiodes, with wide band multi-polarization features are disclosed for increasing the performance of the self-powered sensing nano and microsystem.

The US Patent 8759932B2 discloses photodetectors with plasmonic structures aiming at generating two-dimensional pixel arrays, where each pixel has its own plasmonic grating, with its specific subwavelength period and polarization of the incident electromagnetic radiation with respect to the grating vector. Two or more such pixels (combined in a macro-pixel) are electrically connected in parallel and are formed on a single metal-semiconductor metal (MSM) photodetector device so that to detect electromagnetic radiation of larger bandwidth and different polarizations of the electric field with respect to grating. The novelty of the invention comes from decoupling the optical function from the electrical function of the plasmonic grid. Thus, the metallic plasmonic grid placed on the top side of the device in front of incident electromagnetic radiation remains only with the optical function of surface plasmon generation, while the electrical contact to n-type region formed in the CdHgTe or CdZnTe semiconductor is performed on the back side of the photodetector. Unfortunately, this is a complex non-planar technology, where one needs double-side alignment of the masking process on the back side of the wafer with respect to front side pattern, and also it needs drilling and making metal vias through the entire wafer for contacting the n-type region of the semiconductors.

The US Patent 8759932 B2 discloses a photodetector with plasmonic structure, consisting of a plurality of out of plane 3 D semiconducting light receiving elements and a periodic metal pattern located in the horizontal plane, in between 3D geometry. The out of plane 3D light receiving elements have different shapes, like cylinders, truncated pyramids or pyramids, while the in-plane metal pattern distributed in between and at the bottom of the 3D elements is in contact with the semiconductor and forms a periodic plasmonic structure of the photodiode tuned for the detection of certain wavelength as discussed in the background section. Similar to the effect of anisotropic etching of silicon surface which is aiming to reduce the effect of the incidence angle of the light on efficiency of the solar cells, in this case, the 3D "rough" surface of the photodetector increases the area of light receiving elements and decreases the dependency of the photodetector responsivity on the incidence angle.

SUMMARY

The present disclosure presents an innovative design and technology concept for an on-chip integrated self-powered nano and microsystem containing a plasmonic interdigitated metal-semiconductor-metal (SMS) Schottky thin film solar cell as energy harvester, an in-plane interdigitated supercapacitor as power source, and a sensor with interdigitated electrodes. The sensor can be an interdigitated plasmonic MSM hot electron Schottky photodetector, or an ultralow power chemiresistive gas sensor. The photoactive material of plasmonic solar cell and photodetector and the electroactive material of microsupercapacitor are based on the same chalcogenide semiconductor, like $Sb_2S_3$, and similar materials. The chemiresistive gas sensor contains a sensitive layer based on ternary nanocomposites, like single-walled carbon nanohorn-$SnO_2$-polyvinylpyrrolodine and can be used for ethanol and relative humidity detection. The three modules of the self-powered on-chip integrated nano and microsystem are all connected in series and have a common electrode between the solar cell and supercapacitor and another one between the supercapacitor and the sensor. The operation of the integrated nano and microsystem is controlled from the external circuit by means of two switches. One switch decouples the sensor during charging time, and the other one decouples the plasmonic solar cell during discharging time of the supercapacitor, when the sensor is powered. Novel design concepts for multiband, chirped wideband and, multi-polarization plasmonic solar cells and photodetectors are also disclosed here, so that to assure an increase of the conversion efficiency of the plasmonic solar cell and thus enough energy to be stored by the supercapacitor and finally delivered to the sensor, during the active mode.

**BRIEF DESCRIPTION OF DRAWINGS**

The embodiments of the present disclosure will be described only as an example, by reference to Figs. 1-6, as follows.

Fig. 1. Schematic block diagram of the modules of an integrated self-powered sensing nano and microsystem and their interconnection.

Fig. 2. The schematic lay-out of the top-view and local cross-section views of a self-powered sensing nano and microsystem.

Fig.3. An example of design and lay-out of a multiband single-polarization interdigitated plasmonic solar cell.

Fig. 4. Spectral photocurrent of a multiband single-polarization plasmonic solar cell.

Fig. 5. Correlation between the grating period and the resonant incident wavelength in the visible and near-infrared spectrum for the case of surface plasmon resonance at the interface between gold and $Sb_2S_3$ layer, at normal incidence and first order of diffraction.

Fig. 6. Multiband, multi-polarization plasmonic solar cell lay-out.

**DETAILED DESCRIPTION**

The following description should be read and understood with reference to the above drawings. These drawings are not necessarily at scale and are not intended to limit the scope of the invention. Although different examples of the design and technology of the novel integrated self-powered nano and microsystem containing plasmonic solar cells, microsupercapacitor and plasmonic photodetectors or other sensors are illustrated in those figures, the people skilled in the art will recognize that the provided examples have many suitable alternatives that may be utilized, without departing from the content of the present invention.

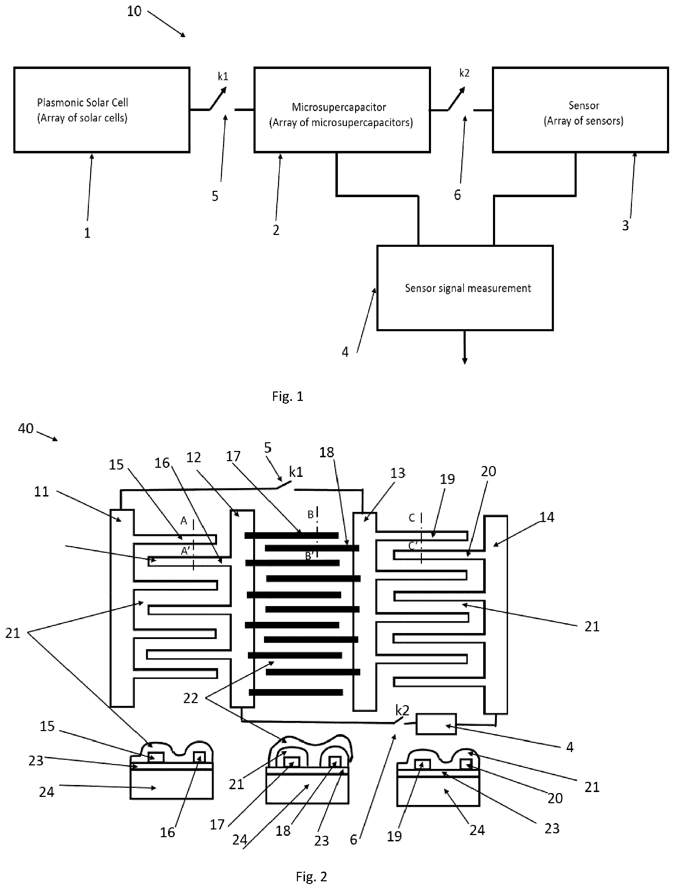

Fig. 1 shows a schematic block diagram a self-powered sensing nano and microsystem, 10, consisting of a plasmonic thin film metal-semiconductor-metal (MSM) Schottky solar cell, 1, a supercapacitor, 2, a sensor, 3, and its signal measurement module, 4, and their operation timeline, driven by the outside switches, 5, and, 6. The detailed description of each module will be presented in the next figures. The operation of the self-powered sensing nano and microsystem is under control of the processor, not shown here, which defines the active and sleeping mode of each module, taking into consideration the operation modes of the sensors, 3, the charging and discharging time of the microsupercapacitor, 2, and the electric energy needed to be delivered by the solar cell, 1. For a very reliable operation of the self-powered sensing nano and microsystem, 10, during the charging time of the microsupercapacitor, 2, the k1 switch, 5, is closed and the k2 switch, 6, is open. During the period of time when the microsupercapacitor, 2, is acting as a power source for the sensor, 3, and measurement module, 4, the k1 switch, 5, is open and the k2 switch, 6, is closed, and thus the sensor 3 enters the active mode when it is able to detect its measurand. One of the specific features of the integrated nano and microsystem, 10, is that the plasmonic solar cell, 1, has a common electrode with the microsupercapacitor, 2, and the microsupercapacitor, 2, has a common electrode with the sensor, 3. The operation mode of the self-powered nano and microsystem, 10, is triggered by the fact that the sensor, 3, can be in the active mode, only intermittently, for short periods of time, for example, a few seconds for each minute, depending anyway on the application request. As shown in Fig. 1, the self-powered integrated sensing nano and microsystem, 10, can be composed of an array of plasmonic solar cell, 1, an array of microsupercapacitors, 2, and an array of sensors, 3. The design of the arrays will take into consideration the voltage generated by each solar cell, 1, the maximum voltage applicable on each microsupercapacitor, 2, and obviously the power required by the sensor or array of sensors, 3, and measurement module, 4.

Fig. 2 shows the schematic lay-out, 40, of the top-view and local cross-section views of the integrated self-powered sensing nano and microsystem, 10, from Fig. 1. In Fig. 2, the plasmonic solar cell (#1 in Fig. 1) based on interdigitated thin film, metal-semiconductor-metal Schottky barrier has the metallic comb-like current collectors, 11 and 12 to which a multitude of parallel metal digits, 15, 16 respectively, are connected. The metal current collectors and their digits are deposited directly on a dielectric substrate, 23. From the cross-section view A-A', one can easily identify the plasmonic metallic digits 15 and 16 of the plasmonic solar cell above which a photoactive chalcogenide semiconductor layer 21 is deposited. It is important to notice that the photoactive layer, 21, is continuously covering all the metal digits 15 and 16 and the spacing between them, forming a continuous layer in between the current collectors, 11, and, 12, without covering entirely the current collectors, 11, and 12. The antireflection layer deposited always on top of the solar cell is not shown here to preserve the clarity of the drawing. As mentioned above, the metallic layer for the definition of the current collectors, 11, 12, 13, 14 and their digits, 15, 16, 17, 18, 19, 20 of the integrated sensing nano and microsystem, 40, is deposited directly on the substrate 23/24, i.e., $SiO_2$/Si in this drawing. The substrate could be also, sapphire, glass or even dielectric flexible substrate, like polyimide (PI) and polyethylene terephthalate (PET). In Fig. 2, the in-plane interdigitated microsupercapacitor (#2 in Fig. 1) has the metallic comb-like current collectors 12, and 13, where the current collector, 12 is common to the plasmonic solar cell and microsupercapacitor cell (#3 in Fig. 1). From the cross-section view, B-B' of the microsupercapacitor, one can easily identify the fact that the electroactive semiconducting chalcogenide layer, 21, is conformally covering all the metallic digits 17 and 18 (only), but not the space between them, which is covered with the electrolyte, 22. Similarly, the layer 21, acting as electroactive electrode of the microsupercapacitor (#2 in Fig. 1) is only partially covering the current collectors 12 and 13, so that the photoactive chalcogenide layer 21 of the plasmonic solar cell is not touching the electroactive chalcogenide layer, 21, of the microsupercapacitor. The same reference number, #21, is used for the chalcogenide layer, belonging to both plasmonic solar cell, microsupercapacitor and plasmonic photodetector, as this is deposited simultaneously on the entire wafer and used by all three devices. The entire region between the current collectors, 12, and, 13, is covered by a continuous layer of a quasi-solid-state electrolyte, as those described in the prior art. Again, the electrolyte layer will not cover entirely the current collectors, 12, and 13. In Fig. 2, the interdigitated sensor (#3 in Fig. 1) has the interdigitated comb-like current collectors 13 and 14, with the metallic comb-like current collector, 13, being common to the microsupercapacitor and plasmonic photodetector. In Fig. 2, the switches k1 (#5) and k2 (#6) and the sensor signal measurement module (#4) have the same role, as described in Fig. 1.

In Figs. 1 and 2, the interdigitated sensor (provided with current collectors 13 and 14) can be any type of sensor which can use the interdigitated current collectors (19 and 20), and a specific sensing film deposited above the digits of interdigitated current collectors 13 and 14. In the case, in which the sensor is a plasmonic interdigitated MSM Schottky photodetector, the layer stack of the plasmonic solar cell and of the photodetector is the same, as can be noticed from the cross-section views A-A' and C-C'. It is well-known that the only major difference between a solar cell and a photodiode-type photodetector, consists in the fact that the photodetector is voltage-biased in order to decrease the transit time of the generated photo-charges through the device and depletion capacitance of the device, which will both decrease the response time of the photodevice. With a minor change in the fabrication technology of the integrated self-powered sensing nanosystem, the plasmonic photodetector can be replaced by a chemiresistive gas sensor, as an example. Due to low power constrains of such a self-powered sensing nanosystem, room temperature operating gas sensors are considered as a favorite embodiment. As an example, room temperature chemiresistive sensors for ethanol and RH resistive detection by using sensitive layers based on organic-inorganic ternary composites of oxidized single-walled carbon nanohorns (SWCNH), consisting for example of $SWCNH-SnO_2$-polyvinylpyrrolidine (PVP) are disclosed here.

The family of the semiconducting chalcogenides used as multifunctional materials in Figs. 1 and 2 from above is well known for the photonic applications, being already used as a photoactive material for the realization of the solar cells, as described in the background of this disclosure. In addition, due to the atomic layered structure of these semiconductors, which allows intercalation of the electrolyte ions inside their composition, the chalcogenides compounds are also emerging as an electroactive material for the fabrication of supercapacitors. Thus, in the background of this disclosure it was already mentioned that antimony sulfide, $Sb_2S_3$ was used as both an absorber for solar cell and as an electroactive electrode for supercapacitor. An extension to ternary compounds of $Sb_xSe_{1-x}S_3$, as solid solution with a bandgap between 1.7 and 1.1 eV can be also envisaged to be used as both photoactive layer (#21) and electroactive layer (#21) in Figs 1 and 2. In addition, quaternary chalcogenide, $CuSbSe_xS_{2-x}$ and ternary chalcogenide $CuSbS_2$ compounds, which contain three and two metal ions in their compositions, respectively, have been also proven as both photoactive materials, with large absorption spectrum in the visible region and electroactive materials (Karthik Ramasamy, Ram K. Gupta, Soubantika Palchoudhury, Sergei Ivanov, and Arunava Gupta, Layer-Structured Copper Antimony Chalcogenides (CuSbSexS2-x): Stable Electrode Materials for Supercapacitors, in Chem. Mater. 2015, 27, 379-386, Vineetha Vinayakumar, Study on The Properties of CuSbs2 and CuSbSexS2-x Thin Films for Photovoltaic and Photodetector Applications", Ph.D. Thesis, 2019, Universidad Autónoma de Nuevo Leon.

Realization of plasmonic solar cell and photodetectors described in Figs. 1 and 2 from above, requires the use of the current collectors (11, 12, 13, 14) and their metal digits, 15, 16, 19, 20) to be made from the so-called, plasmonic metals, like gold, aluminum and silver, which have the particular properties of presenting a negative value of the real part of the complex dielectric permittivity in the visible and infrared spectrum of the electromagnetic radiation. This is an essential condition for the generation of the surface plasmon polaritons (SPP) at the interface between these metals and air, or a dielectric or a semiconductor, in the presence of a grating, so that the momentum conservation law to be satisfied, as discussed in the equations [1] and [2] from background. In the same time, the current collector, 12 and 13, and their digits, 17, and ,18, are used for the realization of the electrodes of the microsupercapacitor.

The quasi-solid-state electrolyte, 22, from Fig. 2 plays a major role in determining the maximum voltage applicable per each microsupercapacitor. From this point of view, it is well known that organic quasi-solid-state electrolytes have a voltage window higher than 2.5, but below 5 volts. The Gel-Polymer Electrolytes (GPE) represent a large family of quasi solid electrolytes in which the liquid electrolyte is trapped in host polymer. This class contains polyvinyl alcohol (PVA)/$H_2SO_4$, PVA/KOH. An advanced class of GPE was recently obtained by incorporating redox active additives like KI, hydroquinone (HQ), methylene blue (MB) and others to (PVA)/$H_2SO_4$, PVA/KOH, and thus obtaining high ionic conductivity quasi-solid polymers like PVA-KOH-KI. (Haijun Yu, Jihuai Wu, Leqing FanKaiqing, Xu Xin, Zhong Youzhen Lin, JianmingLin, Improvement of the performance for quasi-solid-state supercapacitor by using PVA-KOH-KI polymer gel electrolyte, Electrochimica Acta, Volume 56, Issue 20, 1 August 2011, Pages 6881-6886. This family of electrolytes can be used within this invention as a model electrolyte.

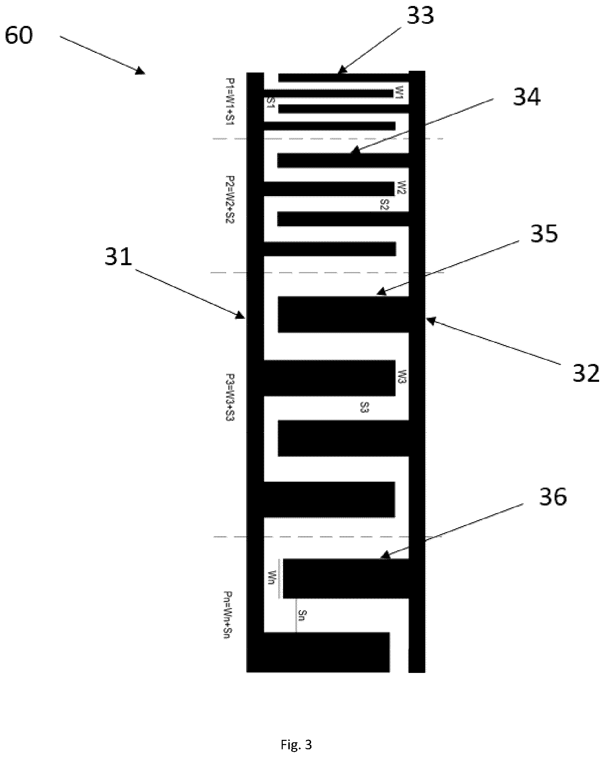

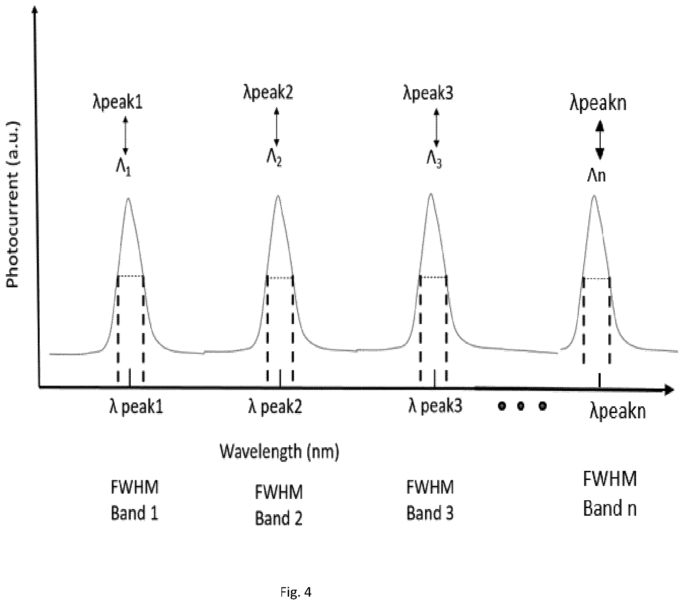

. As presented in the background of this invention, the plasmonic solar cell is a wavelength and polarization sensitive device. As a wavelength selective photonic device, the plasmonic solar cell is acting as a wavelength filter with a sharp maximum photocurrent generated at a certain incident resonant wavelength ($\lambda_{peak}$), at which surface plasmon polaritons are generated. Outside a wavelength band centered on $\lambda_{peak}$, the photon conversion efficiency decreases. For a certain grating period, incidence angle and order of diffraction, the value of the $\lambda_{peak}$ can be calculated by means of equations 1] and [2] from the background of this invention. This value $\lambda_{peak}$ and associated wavelength band can be correlated with the period of the metal interdigitated grating, $\Lambda$, which is equal to the sum of the metal digit width, W, and spacing between two subsequent digits, S. Based on this theoretical background, the present invention presents in Fig. 3 an innovative plasmonic solar cell, which we call multiband, single-polarization plasmonic solar cell, 60, in which a multitude of wavelength bands of the solar spectrum can be harvested generating enhanced photocurrents. The multiband plasmonic solar cell consists in connecting in parallel a multitude of gratings, each grating having its period, as follows: $\Lambda1=P1=W1+S1$, $\Lambda2=P2=W2+S2$, $\Lambda3=P3=W3+S3$, ..., $\Lambda n=Pn=Wn+Sn$), and all gratings being connected to the same current collectors, 31, 32, as shown in Fig. 3. Thus, in accordance with Fig. 4, the digits 33 with their width W1 and the spacing between them equal to S1, will define the grating with the period $\Lambda1= P1=W1+S1$, which will generate the enhanced photocurrent having the wavelength Bandl with full width half maximum (FWHM1) centered on $\lambda_{peak1}$. Similarly, the digits 34, with width equal to W2, and spacing equal to S2, characterized by grating period P2=W2+S2, will contribute to the photocurrent generated in the wavelength Band2, with FWHM2 centered around $\lambda_{peak2}$. The same rule will occur for all the gratings of the multiband plasmonic solar cell from Fig. 3. The above operation description of the multiband single-polarization plasmonic solar cell is presented in the frequency (wavelength) domain. As all these gratings, with periods $\Lambda1$, $\Lambda2$, $\Lambda3$, ... An, operate in parallel from electrical point of view, it is obvious that in the time domain, the photocurrent is much enhanced due to spectral contribution of the multitude of solar wavelength bands. From the best of our knowledge this is for the first time when such a multiband single-polarization plasmonic solar cell is disclosed.

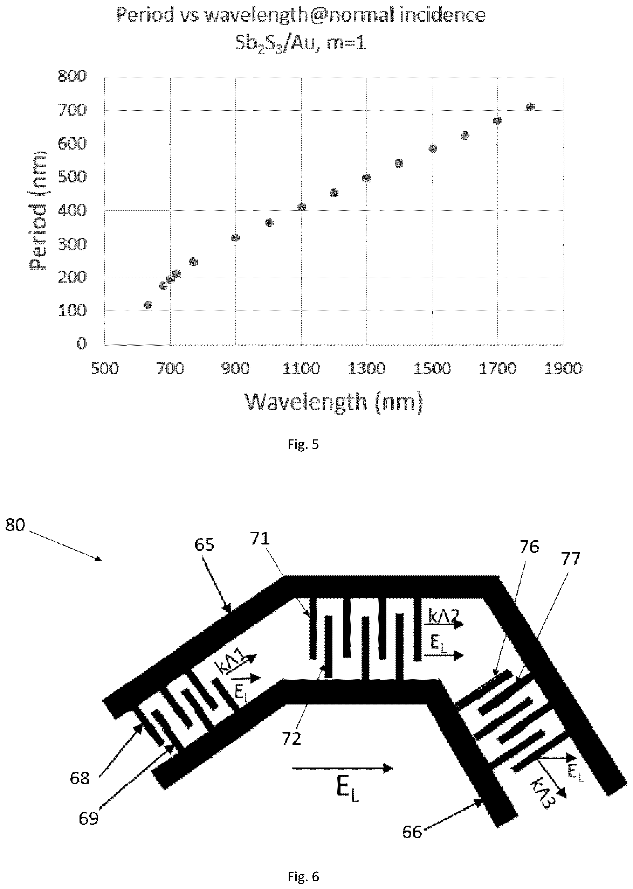

Based on the equations [1] and [2], from the background and considering the optical constants of $Sb_2S_3$ and gold as function of wavelength, Fig. 5 shows the analytical correlation between period of the grating and the wavelength of the incident light for which surface plasmon polaritons can be generated at the interface between polycrystalline $Sb_2S_3$ and gold, for the case of normal incidence (incidence angle is equal to zero) of the solar light and first order of diffraction, m=1. From Fig. 5 one can notice that for each resonant wavelength on the abscissa, the associated period of the metal grating is much smaller than the wavelength, and this is why the plasmonic solar cell is a subwavelength device, involving nano and microlithography for its technological implementation.

In the case of gold used as a plasmonic metal for the realization of the plasmonic solar cell, microsupercapacitor and sensor, the conditions from equations [1] and [2] are fulfilled in the visible spectrum for red light wavelengths higher than 630 nm, and then continues with the near-infrared spectrum. As the absorption edge of the polycrystalline $Sb_2S_3$ is equal to about 700 nm, it becomes obvious that the solar light is absorbed in the $Sb_2S_3$ film in the wavelength range between 630 nm and 700 nm. For wavelengths higher than the absorption edge, 700 nm, the multiband plasmonic solar cell based on thin film interdigitated MSM Schottky barrier from Fig. 3 will absorb the light in the metal near the interface with $Sb_2S_3$ and generate hot electrons. Those hot electrons with energy higher than the barrier height between gold and $Sb_2S_3$ will surmount the Schottky barrier energy and create the SPP enhanced photocurrent. More specifically, photons with energy higher than 0.5 eV but lower than the bandgap of polycrystalline $Sb_2S_3$ (1.7 eV) will be able to generate photocurrents in the spectral region specific to telecom wavelengths (1260 nm-1675 nm).

In another embodiment, an alternative approach to the multiband plasmonic solar cell presented above, disclosed in this invention is the chirped wideband plasmonic solar cell, in which the period of the grating is quasi-continuously changed from digit to digit, by changing either the width of the metal digit, or the spacing between subsequent digits, or both of them. According to Fig. 5, for the case of normal incidence and first order of diffraction, for the chirped wideband plasmonic solar cell based on interdigitated MSM Schottky barrier fabricated with gold metallization and $Sb_2S_3$, the grating period can be quasi-continuously increased from a value equal to 100 nm to 700 nm for solar light harvesting in the spectral domain from 630 nm to 1800 nm. From the best of our knowledge, this is for the first time, when a chirped wideband single-polarization plasmonic solar cell based on thin film MSM Schottky barrier ($Sb_2S_3$/Au) covering a large spectrum of solar energy harvesting is disclosed.

As mentioned in the background of this invention, the plasmonic solar cell is polarization sensitive. Taking into consideration that the solar light is only partially polarized, and this partial polarization occurs due to light scattering on water vapors and dust particles from the atmosphere, it is very important to increase the capability of the plasmonic solar cell to harvest the light of different polarizations. For a certain polarization of the solar light, the generated photocurrent has a maximum value when the electric field vector of the light, $E_L$, is colinear with the grating vector, $K_\Lambda$. As known from theory, the direction of the grating vector is perpendicular to the parallel metal digits of the grating. Under these considerations, it is for the first time when a multiband multi-polarization plasmonic solar cell able to provide a maximum generated photocurrent on more directions of the incident solar light is disclosed. Fig. 6 presents an example of a multiband multi-polarization plasmonic solar cell, 80, based on thin film interdigitated MSM Schottky barrier. From this figure it is obvious that the current collectors, 65, and 66, are gathering the SPP enhanced photocurrents generated by three different gratings, as follows. The grating defined by the multitude of digits, 68, and ,69, has a grating vector, $k_{\Lambda1}$, which makes a certain angle with the electric field vector of the light; the grating defined by the multitude of digits, 71, and, 72, has a grating vector, $k_{\Lambda2}$, which makes an angle equal to zero with the same electric field vector, $E_L$, and the grating defined by the metal digits, 76, and, 77, which has a grating vector, $k_{\Lambda3}$, and which makes a certain angle with the same electric field vector, $E_L$. In this example from Fig. 6, the maximum generated photocurrent is given by the grating defined by the vector $k_{\Lambda2}$, as the two vectors $k_{\Lambda2}$ and $E_L$ are colinear. In the same time, there is sun light incident on the plasmonic solar cell, 80, which has another polarization. For example, if the electric field vector, $E_L$, is parallel with the grating vector $k_{\Lambda3}$, then, the grating defined by $k_{\Lambda3}$ will provide the maximum generated current. Thus, the advantage of the multiband multi-polarization plasmonic solar cell, 80, from Fig. 6 is clearly demonstrated. This is only an example and a multitude of gratings can be incorporated between the current collectors 65 and 66, which can have a multitude of shapes, and angles between the electric field vectors and those different grating vectors.

In another embodiment, a chirped wideband, multi-polarization plasmonic solar cell based on thin film interdigitated MSM Schottky barrier can be developed, where a quasi-continuous variation of the period of the grating is done, by quasi-continuously varying the width W of the digits and/or the spacing, S, between them. Thus, a wide band of resonating wavelengths may be obtained. The current collectors will follow different directions and shapes, as described above, so that the incident solar light with a multitude of polarizations to be able to generate an enhanced plasmonic photocurrent by aligning the different electric field vectors to those different grating vectors.

As the plasmonic solar cell may have different geometries of the current collectors and their associated metal digits, as presented in Figs. 3 and 5, the common current collector of the plasmonic solar cell with microsupercapacitor may determine the geometry of the second current collector of the supercapacitor and its metal digits, and similarly, the common current collector of the microsupercapacitor with the sensor may determine the geometry of the second current collector of the sensor and its metal digits.

In a preferred embodiment, the sensor is a thin film plasmonic photodiode based on MSM interdigitated hot electron Schottky barrier between gold and polycrystalline $Sb_2S_3$ chalcogenide semiconductor. The design of the geometry of the plasmonic photodiode can be made so that the device to detect the near infrared light in the telecom wavelength band from 1260 to 1675 nm. Thanks to the wavelength selectivity of the plasmonic photodiode, the grating period of the device can be designed so that only a single telecom band like, C band (1530-1565) nm, or L band (1565-1625) nm to be detected. In another embodiments, the entire telecom wavelength band can be detected, by using multi-band multi-polarization plasmonic photodetectors, following the same design concept as described in the case of plasmonic solar cell, in the Figs. 3-6. As shown in Fig. 2, the plasmonic photodetector which is on chip-integrated with supercapacitor and the plasmonic solar cell has the same fabrication technology as the plasmonic solar cell.

In another embodiment, the sensor which is loading the supercapacitor can be an ultralow power, room temperature chemiresistive gas sensor for the detection of relative humidity, or ethanol, or both of them with the discrimination between them is made by using an array of sensor and sensor data fusion techniques. In the case of the chemiresistive gas sensor loading the supercapacitor, the fabrication process consists in deposition of a sensing film after metal deposition and its configuration in an interdigitated structure, as described in Fig. 2. For example, the sensing film is a ternary organic-inorganic composite of a carbonic nanomaterial like consisting of single-walled carbon nanohorn (SWCNH), polyvinylpyrrolidone (PVP) and $SnO_2$ nanoparticles. The film is obtained from the above suspension by drop coating technique using a dedicated dispenser.

The first example of technology process map, consistent with the fabrication of the self-powered sensing nanosystem based on on-chip plasmonic solar cell, microsupercapacitor and plasmonic photodetector is described below as follows:

1. Selection of the dielectric substrate. This can be a silicon wafer on which a $SiO_2$ film with thickness of about 0.5-1 $\mu$m is thermally grown, or any dielectric substrate, like sapphire or glass or even dielectric flexible substrate, like polyimide (PI) or polyethylene terephthalate (PET) on which specific microelectronic processes can be performed.

2. Selection of the plasmonic metal type. This can be aluminum, gold or silver. Taking into consideration that the plasmonic metal layer serves as both current collector and metal digits for plasmonic solar cell and supercapacitor, and the quasi-solid-state electrolyte may be in contact with these current collectors, the preferred option for plasmonic metal may be gold, which assures chemical inertness and good reliability of the entire nanosystem.

3. Deposition and patterning of the photoresist specific to the lift-off technology for metal deposition. After photoresist patterning, the photoresist is removed from regions where the current collector and metal digits will be deposited directly on the substrate.

4. Deposition of the plasmonic metal layer above the patterned photoresist. In the case of gold deposition, the process will be performed in two steps. In the first step an adherence titanium layer of 3-5 nm is deposited on the substrate and then a gold layer with a thickness of 200-300 nm is vacuum deposited.

5. Removal of the gold deposited above the photoresist by performing a photoresist removal process in a dedicated remover agent or an organic solvent.

6. Deposition of semiconductor chalcogenide film on the substrate containing the patterned metallization. As an example, here, $Sb_2S_3$ is considered as a representative of these photoactive and electroactive chalcogenide semiconductor materials. In the prior art, there are many methods for the deposition of the $Sb_2S_3$ film, and one can include them here. For example, one can mention chemical bath deposition, physical vapor deposition, like sputtering, or chemical vapor deposition from liquid source.

7. Thermal annealing of the $Sb_2S_3$ film at 300°C, for 30 minutes in nitrogen atmosphere for obtaining a polycrystalline state of the film and preserving the sulfide composition.

8. Deposition and patterning of the photoresist mask layer for the realization of the selective etching of the $Sb_2S_3$ layer from the surface of the wafer.

9. Selective plasma etching of the $Sb_2S_3$ layer by a reactive ion etching (RIE) processing in the presence of the photoresist mask. The remaining $Sb_2S_3$ film from the composition of the plasmonic solar cell, microsupercapacitor and plasmonic photodetector will be consistent with the geometry defined in Fig. 2.

10. Selective deposition of the quasi-solid state gel polymer electrolyte like PVA-KOH-KI above the surface of the microsupercapacitor, without fully covering the current collectors 12 and 13 from Fig. 2.

The second example of technology process map consistent with the fabrication of the self-powered sensing nanosystem based on on-chip plasmonic solar cell, microsupercapacitor and chemiresistive gas sensor is described below as follows. The first nine process steps from the first example from above are the same. However, in this case, the sensor contains a $Sb_2S_3$ layer only partially above the current collector 13, as shown with black color in Fig. 2. In this case, a suspension consisting of SWCNH, $SnO_2$ and PVP in the weight ratio 1/1/1 (as an example) is deposited by dropping method above the interdigitated portion of the current collectors 13 and 14 from Fig. 2. After thermal annealing of the sensor at a temperature of 60°C for 24 hours, in vacuum, consolidation of the sensing layer is done. The final step of the self-powered sensing nanosystem is again the selective deposition of the quasi-solid state redox active gel polymer electrolyte above the microsupercapacitor, as shown in Fig. 2.

For those skilled in the art, it is easy to further design other layouts of self-powered sensing micro and nanosystem based on thin film interdigitated MSM Schottky plasmonic solar cell, microsupercapacitor and plasmonic photodiode, or gas sensor, and remain within the scope of the claim attached hereto. Therefore, it will be understood that this disclosure is, in many respects, only illustrative. Changes may be made at detail level, in the arrangement of the gratings, number of gratings, shape of collecting electrodes, layout size and digits orientation with respect to collecting electrodes without exceeding the scope of the invention.

**Claims**

1. A self-powered on-chip integrated sensing nano and microsystem comprising:

   - an interdigitated thin film plasmonic solar cell metal-semiconductor-metal Schottky barrier between a plasmonic metal and a chalcogenide semiconductor,
   - an interdigitated in-plane microsupercapacitor with a current collector common with the plasmonic solar cell, and
   - an interdigitated sensor with a current collector common with the interdigitated microsupercapacitor.

2. The integrated sensing nano and microsystem from claim 1, where the plasmonic solar cell is multiband, single-polarization.

3. The integrated sensing nano and microsystem from claim 1, where the plasmonic solar cell is multiband, multi-polarization.

4. The integrated sensing nano and microsystem from claims 1, where the plasmonic solar cell is wideband chirped, multi-polarization, being able to harvest solar energy in the wavelength band from visible to near infrared.

5. The integrated sensing nano and microsystem from claim 1, where the electroactive electrode of the in-plane microsupercapacitor contains the same chalcogenide semiconductor material which is used as photoactive material for the plasmonic solar cell and plasmonic photodetector.

6. The integrated sensing nano and microsystem from claim 1, where the interdigitated sensor is a plasmonic thin film interdigitated metal-semiconductor-metal multiband multi-polarization hot electrons Schottky barrier photodetector.

7. The integrated sensing nano and microsystem from claim1, where the interdigitated sensor is an ultralow power room temperature chemiresistive gas sensor.

8. The integrated sensing nano and microsystem from claim 1, where the sensor is decoupled from the microsupercapacitor by an external switch, when the microsupercapacitor is charging from the plasmonic solar cell.

9. The integrated sensing nano and microsystem from claim 1, where the plasmonic solar cell is decoupled from the microsupercapacitor by an external switch, when the sensor is powered by the microsupercapacitor.

10. A method for the on-the-same-chip fabrication of a self-powered nano and microsystem comprising:

    - Deposition and patterning of a photoresist layer specific to the lift-off technology for the metal deposition on a dielectric substrate,
    - Deposition of a plasmonic metal layer above the patterned photoresist,
    - Removal of the plasmonic metal layer deposited above the photoresist by means of a remover agent,
    - Deposition of a semiconductor chalcogenide film on the substrate containing the remaining patterned plasmonic metal,
    - Thermal annealing of the deposited semiconductor chalcogenide film for obtaining a polycrystalline state of the film,
    - Deposition and patterning of the photoresist mask layer for the realization of the selective etching of the semiconductor chalcogenide film,
    - Selective plasma etching of the semiconductor chalcogenide layer by a reactive ion etching processing in the presence of the patterned photoresist mask,

    - Selective deposition of a continuous layer of a quasi-solid state gel polymer electrolyte above the surface of the microsupercapacitor, without fully covering the current collectors.

11. Method from claim 10, where the same chalcogenide semiconductor is used as photoactive layer for the fabrication of the interdigitated plasmonic solar cell, as electroactive layer for the interdigitated microsupercapacitor and as photoactive layer for the interdigitated plasmonic MSM hot electron Schottky photodetector.

12. Method from claim 11 where the chalcogenide semiconductor film is $Sb_2S_3$, $CuSbS_2$, $Sb_xSe_{1-x}S_3$, $CuSbSe_xS_{2-x}$

13. Method from claim 11, where the photoactive semiconductor chalcogenide film of the Schottky photodetector is replaced by a sensitive film specific to an ultralow power chemiresistive gas sensor.

14. Method from claim 10, where the plasmonic metal layer for the entire self-powered sensing nano and microsystem is made of gold with thickness of 200-300 nm deposited on titanium barrier layer of 3-5 nm.

15. Method from claim 14, where the gold/titanium current collector is deposited on the rigid or the flexible dielectric substrate and the chalcogenide semiconductor is deposited on the patterned current collector.

10

Plasmonic Solar Cell
(Array of solar cells)

k1

Microsupercapacitor
(Array of microsupercapacitors)

k2

Sensor
(Array of sensors)

5

2

6

1

3

Sensor signal measurement

4

Fig. 1

40

11 15 16 12 17 5 18 13 19 20 14

k1

A
A'

B
B'

C
C'

21

21

22

k2

4

15
23
24

16

17
24

21
18
23

6

19

20
21
20
23
24

Fig. 2

Fig. 3

Fig. 4

## Period vs wavelength@normal incidence
## $Sb_2S_3$/Au, m=1

Fig. 5

Fig. 6

Europäisches
Patentamt

European
Patent Office

Office européen
des brevets

## EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | WO 2018/195383 A1 (SABIC GLOBAL TECHNOLOGIES BV [NL]; ODEH IHAB N [US]) 25 October 2018 (2018-10-25) * paragraphs [0027] - [0030]; figures 1-3 * | 1-15 | INV. H01L27/142 H01L27/144 H01L49/02 H01L31/07 H01L31/0224 |
| A | TIAN ZHENGNAN ET AL: "Printable magnesium ion quasi-solid-state asymmetric supercapacitors for flexible solar-charging integrated units", NATURE COMMUNICATIONS, vol. 10, no. 1, 29 October 2019 (2019-10-29), XP93009422, DOI: 10.1038/s41467-019-12900-4 Retrieved from the Internet: URL:https://www.nature.com/articles/s41467-019-12900-4> * Page 2. Illustrating the configuration of solar-charging units.; figure 1a * | 1-15 | |
| A | US 2013/112258 A1 (PARK JOONG-HYUN [KR] ET AL) 9 May 2013 (2013-05-09) * paragraphs [0027] - [0047]; figures 1-3 * | 1-15 | |
| A | ZHITAO ZHANG ET AL: "Integrated Polymer Solar Cell and Electrochemical Supercapacitor in a Flexible and Stable Fiber Format", ADVANCED MATERIALS, VCH PUBLISHERS, DE, vol. 26, no. 3, 31 October 2013 (2013-10-31), pages 466-470, XP071814192, ISSN: 0935-9648, DOI: 10.1002/ADMA.201302951 * the whole document * | 1-15 | TECHNICAL FIELDS SEARCHED (IPC) H01L |

The present search report has been drawn up for all claims

| Place of search | Date of completion of the search | Examiner |
|---|---|---|
| Berlin | 19 December 2022 | Rodríguez-Gironés, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                   
& : member of the same patent family, corresponding document

## ANNEX TO THE EUROPEAN SEARCH REPORT
## ON EUROPEAN PATENT APPLICATION NO.

EP 22 46 5542

This annex lists the patent family members relating to the patent documents cited in the above-mentioned European search report.
The members are as contained in the European Patent Office EDP file on
The European Patent Office is in no way liable for these particulars which are merely given for the purpose of information.

19-12-2022

| Patent document cited in search report | | Publication date | Patent family member(s) | | Publication date |
|---|---|---|---|---|---|
| WO 2018195383 | A1 | 25-10-2018 | NONE | | |
| US 2013112258 | A1 | 09-05-2013 | CN | 103094368 A | 08-05-2013 |
| | | | EP | 2590223 A2 | 08-05-2013 |
| | | | JP | 2013098527 A | 20-05-2013 |
| | | | KR | 20130049024 A | 13-05-2013 |
| | | | US | 2013112258 A1 | 09-05-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4213798 A
- US 11127865 B2
- WO 2018195383 A1
- US 8759932 B2

**Non-patent literature cited in the description**

- **ZHITAO ZHANG ; XULI CHEN ; PEINING CHEN ; GUOZHEN GUAN ; LONGBIN QIU ; HUIJUAN LIN ; ZHIBIN YANG ; WENYU BAI ; YONGFENG LUO ; HUISHENG PENG.** *Integrated Polymer Solar Cell and Electrochemical Supercapacitor in a Flexible and Stable Fiber Format, Adv. Mater.,* 2013
- **C.H. NG ; H.N. LIM ; S. HAYASE ; I. HARRISON ; A. PANDIKUMAR ; N.M. HUANG.** Potential active materials for photo-supercapacitor. *A review, Electrochimica, dx.doi.org /10.1016/ j.electacta .2017.04.003*
- **S.C.LAU ; H.N.LIM ; T.B.S.A.RAVOOF ; M.H.YAACOB ; D.M.GRANT ; R.C.I.MACKENZIE ; I.HARRISON ; N.M.HUANG.** A three-electrode integrated photo-supercapacitor utilizing graphene-based intermediate bifunctional electrode. *Electrochimica, dx.doi.org/10.1016/j.electacta.2017.04.003*
- **ZHENGNAN TIAN ; XIAOLING TONG ; GUAN SHENG ; YUANLONG SHAO ; LIANGHAO YU ; VINCENT TUNG ; JINGYU SUN ; RICHARD B. KANER ; ZHONGFAN LIU.** Printable magnesium ion quasi-solid-state asymmetric supercapacitors for flexible solar-charging integrated units. *NATURE COMMUNICATIONS,* 2019, vol. 10, 4913, https://doi.org/10.1038/s41467-019-12900-4 | www.nature.com/naturecommunications
- **ZHONG LIN WANG.** Self-Powered Nanosensors and Nanosystems. *Adv. Mater.,* 15 November 2011, 1-6
- **S.M. SZE ; D.J. COLEMAN JR. ; A LOYA.** *Current transport in metal-semiconductor-metal (MSM) structures, Solid-State Electronics,* 1971, vol. 14, 1209-1218
- **JULIAN B.D. SOOLE ; HERMAN SCHUMACHER.** InGaAs Metal-Semiconductor-Metal Photodetectors for Long Wavelength Optical communications. *IEEE Journal of Quantum Electronics,* March 1991, vol. 27 (3

- **YOON HEE JANG ; YU JIN JANG ; SEOKHYOUNG KIM ; LI NA QUAN ; KYUNGWHA CHUNG ; DONG HA KIM.** Plasmonic Solar Cells: From Rational Design to Mechanism Overview. *Chem. Rev.,* 2016, vol. 116, 14982-15034
- **C. GENET ; T.W. EBBESEN.** Light in tiny holes. *Natures,* 04 January 2007, vol. 445
- **C. GENET ; T. W. EBESSEN.** Light in tiny holes. *Nature Reviews,* 04 January 2007, vol. 445
- **O. SAVADOGO ; K.C. MANDAL.** Low Cost Schottky Barrier Solar Cells Fabricated on CdSe and Sb2S3 Films Chemically Bath Deposited with Silicotungstic Acid. *Journal of Electrochemical Society,* 1994, vol. 141 (10), 2871-2877
- **M. JESTL ; I. MARAN ; A. KOCK ; W. BEINS ; TINGL ; E. GORNIK.** Polarization sensitive surface plasmon Schottky detectors. *OPTIC LETTERS,* 15 July 1989, vol. 14 (14
- **KARADE ; SWAPNIL S. et al.** Novel Application of Non-Aqueous Chemical Bath Deposited Sb2S3 Thin Films as Supercapacitive Electrode. *International Journal of Hydrogen Energy,* 2016, vol. 41 (46), 21278-21285
- **CORNEL COBIANU ; BOGDAN-CATALIN SERBAN ; NICULAE DUMBRAVESCU ; OCTAVIAN BUIU ; VIOREL AVRAMESCU ; CRISTINA PACHIU ; BOGDAN BITA ; MARIUS BUMBAC ; CRISTINA-MIHAELA NICOLESCU ; COSMIN COBIANU.** Organic-Inorganic Ternary Nanohybrids of Single-Walled Carbon Nanohorns for Room Temperature Chemiresistive Ethanol Detection. *Nanomaterials,* 2020, vol. 10 (25), 52
- **SERBAN, B.-C. ; COBIANU, C. ; BUIU, O. ; BUMBAC, M. ; DUMBRAVESCU, N. ; AVRAMESCU, V. ; NICOLESCU, C.M. ; BREZEANU, M. ; PACHIU, C. ; CRACIUN, G. et al.** Ternary Nanocomposites Based on Oxidized Carbon Nanohorns as Sensing Layers for Room Temperature Resistive Humidity Sensing. *Materials,* 2021, vol. 14, 2705, https://doi.org/10.3390/ma14112705

- **KARTHIK RAMASAMY ; RAM K. GUPTA ; SOU-BANTIKA PALCHOUDHURY ; SERGEI IVANOV ; ARUNAVA GUPTA.** Layer-Structured Copper Antimony Chalcogenides (CuSbSexS2-x): Stable Electrode Materials for Supercapacitors. *Chem. Mater.,* 2015, vol. 27, 379-386
- Study on The Properties of CuSbs2 and CuSbSexS2-x Thin Films for Photovoltaic and Photodetector Applications. **VINEETHA VINAYAKU-MAR.** Ph.D. Thesis. Universidad Autónoma de Nuevo Leon, 2019

- **HAIJUN YU ; JIHUAI WU ; LEQING FANKAIQING ; XU XIN ; ZHONG YOUZHEN LIN ; JIANMINGLIN.** Improvement of the performance for quasi-solid-state supercapacitor by using PVA-KOH-KI polymer gel electrolyte. *Electrochimica Acta,* 01 August 2011, vol. 56 (20), 6881-6886